# EUROPEAN PATENT APPLICATION

(11) **EP 1 120 688 A1**
(43) Date of publication of application: **01.08.2001**
(21) Application number: 01300667.1
(22) Date of filing: 25.01.2001
(51) Int. Cl.: G03F 7/00, H05K 1/00

(54) **Laminate structure and method of manufacturing the same**

(30) Priority: 28.01.2000 JP 2000020204
(71) Applicant: Tohoku University, Sendai 980-8577 (JP)
(72) Inventor: Matsuura, Takashi, Sendai-shi, Miyagi-ken (JP); Murota, Junichi, Sendai-shi, Miyagi-ken (JP)
(74) Representative: Butcher, Ian James

(57) **Abstract**

Disclosed is a method of manufacturing a laminate structure, comprising the steps of laminating a plurality of photosensitive material layers (11, 12) one upon the other to form a laminated photosensitive layer, the photosensitive characteristics of at least one of the photosensitive material layers (11, 12) differing from those of the other photosensitive material layers (11, 12), applying a light exposure treatment to the laminated photosensitive layer a plurality of times under different light exposure conditions so as to transfer desired patterns to the plural photosensitive material layers (11, 12), and developing the plural photosensitive material layers (11, 12) having the patterns transferred thereto.

## Description

The present invention relates to a laminate structure and a method of manufacturing the same, particularly, to a laminate structure prepared by laminating photosensitive material layers and a method of manufacturing the same.

It was difficult in the past to form a three dimensional laminate structure prepared by laminating a plurality of photosensitive material layers differing from each other in the pattern.

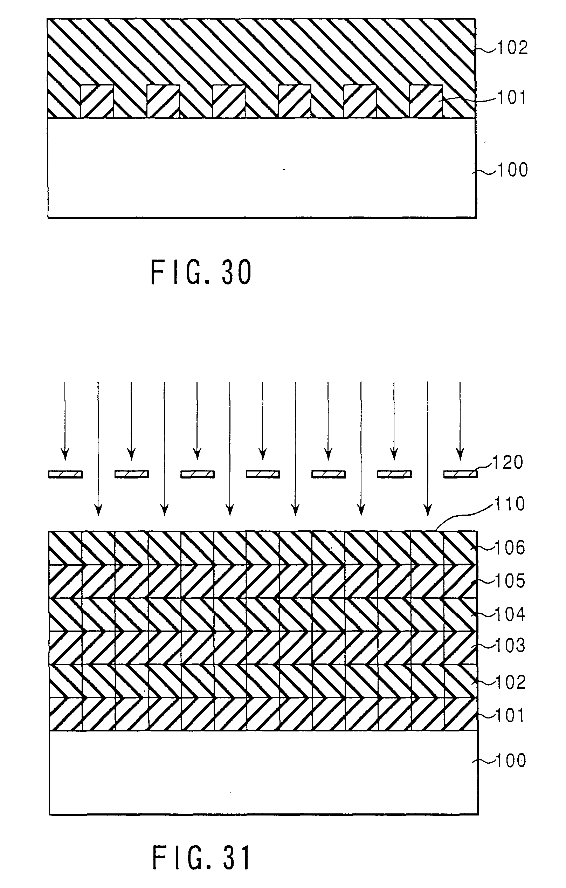

For example, where coating and patterning are successively performed on each of photosensitive material layers, a lower side photosensitive material layer 101 formed on a substrate 100 is already patterned in the step of coating an upper side photosensitive material layer 102, as shown in FIG. 30, with the result that the upper side photosensitive material layer 102 is also formed in regions between adjacent patterns of the lower side photosensitive layer 101. It follows that it is impossible to form a desired three dimensional laminate structure.

Also, where the light exposure is performed after lamination of a plurality of photosensitive material layers, all the photosensitive material layers 101 to 106 including the lowermost layer 101 and the uppermost layer 106 are similarly exposed to an exposure beam passing through a mask 120 so as to form a light exposure region 110. Therefore, it is impossible to make the photosensitive material layers different from each other in the pattern, resulting in failure to form a desired three dimensional laminate structure.

Further, the manufacture of a three dimensional laminate structure requires the step of forming a pattern for each layer, making it impossible to form a desired three dimensional structure with a small number of manufacturing steps.

As described above, it was very difficult in the past to obtain a three dimensional laminate structure prepared by laminating a plurality of photosensitive material layers differing from each other in the pattern.

An object of the present invention, which has been achieved in an attempt to solve the above-noted problem inherent in the prior art, is to provide a laminate structure having a desired pattern and a method of manufacturing the particular laminate structure.

According to a first aspect of the present invention, there is provided a laminate structure prepared by laminating a plurality of photosensitive material layers having desired patterns, wherein a void (vacancy) is formed below an upper photosensitive material layer in a region where upper and lower photosensitive material layers adjacent to each other in the laminating direction do not overlap with each other.

In the laminate structure of the present invention, it is desirable for at least one photosensitive material layer to differ from at least one of the other photosensitive material layers in the photosensitive characteristics and pattern. Also, in the laminate structure of the present invention, it is possible for a non-photosensitive material layer to be interposed between the patterns of the photosensitive material layers adjacent to each other in the laminating direction.

According to a second aspect of the present invention, there is provided a method of manufacturing a laminate structure, comprising the steps of:
laminating a plurality of photosensitive material layers one upon the other to form a laminated photosensitive layer, the photosensitive characteristics of at least one of the photosensitive material layers differing from those of the other photosensitive material layers;
applying a light exposure treatment to the laminated photosensitive layer a plurality of times under different light exposure conditions so as to transfer desired patterns to the plural photosensitive material layers; and
developing the plural photosensitive material layers having the patterns transferred thereto.

In the method of the present invention for manufacturing a laminate structure, it is possible for the step of forming the laminated photosensitive layer to include the process of interposing a non-photosensitive material layer between the photosensitive material layers adjacent to each other in the laminating direction. Also, it is possible for the method of the present invention for manufacturing a laminate structure to include additional steps of loading a fluid in the clearance among the plural photosensitive material layers that have been patterned by the previous developing step, solidifying the fluid to form a solid material, and selectively removing the plural photosensitive material layers so as to leave the solidified material unremoved.

According to a third aspect of the present invention, there is provided a method of manufacturing a laminate structure, comprising the steps of:
repeatedly performing treatments to form at least one photosensitive material layer and to apply a light exposure treatment to the photosensitive material layer so as to transfer a desired pattern to the photosensitive material layer, thereby forming a laminated photosensitive layer consisting of a plurality of photosensitive material layers having patters transferred thereto; and
developing the plural photosensitive material layers having the patterns transferred thereto.

In the method of the present invention for manufacturing a laminate structure, it is possible for the step of forming the laminated photosensitive layer to include the process of interposing a non-photosensitive material layer between the photosensitive material layers adjacent to each other in the laminating direction. Also, it is possible for the method of the present invention for manufacturing a laminate structure to include additional steps of loading a fluid in the clearance among the plural photosensitive material layers that have been patterned by the previous developing step, solidifying the fluid to form a solid material, and selectively removing the plural photosensitive material layers so as to leave the solidified material unremoved.

In the present invention, a plurality of photosensitive material layers are formed and a light exposure treatment is applied to the photosensitive material layers, and finally, a developing treatment is applied to the plural photosensitive material layers. Therefore, the present invention is free from the problem inherent in the prior art. Specifically, in the present invention, in the step of coating the upper photosensitive material layer, the upper photosensitive material layer is not formed in the region between adjacent patterns of the lower photosensitive material layer. Therefore, it is possible to form a void (vacancy) below the upper photosensitive material layer in the portion where the patterns of the adjacent upper and lower photosensitive material layers do not overlap with each other. It follows that it is possible to obtain a three dimensional laminate structure of a high accuracy having a desired shape.

It is also possible to apply selectively a light exposure treatment and a developing treatment to each of the photosensitive material layers having different photosensitive characteristics by laminating the photosensitive material layers having different photosensitive characteristics and applying a light exposure treatment a plurality of times to these photosensitive material layers under different light exposure conditions. In this case, it is possible to apply collectively a light exposure treatment to these photosensitive material layers by periodically laminating a plurality of photosensitive material layers having the same photosensitive characteristics. It follows that it is possible to manufacture a three dimensional laminate structure having a periodic structure and having a very high positional accuracy with a small number of manufacturing steps.

It should also be noted that, where the steps of forming a photosensitive material layer and applying a light exposure treatment to the photosensitive material layer are carried out repeatedly, followed by developing the plural photosensitive material layers, it is possible to suppress the total attenuation amount of light, an electron beam, etc. within each of the photosensitive material layers. As a result, the light exposure treatment can be applied sufficiently to each photosensitive material layer without fail even in the case of laminating a large number of photosensitive material layers, making it possible to obtain a three dimensional laminate structure of a high accuracy.

This summary of the invention does not necessarily describe all necessary features so that the invention may also be a sub-combination of these described features.

The invention can be more fully understood from the following detailed description when taken in conjunction with the accompanying drawings, in which:
FIG. 1 is an oblique view showing a first example of the construction of a laminate structure according to an embodiment of the present invention;
FIG. 2 is an oblique view showing a second example of the construction of a laminate structure according to an embodiment of the present invention;
FIG. 3 is an oblique view showing a part of a first example of the process for manufacturing a laminate structure according to an embodiment of the present invention;
FIG. 4 is an oblique view showing a part of a first example of the process for manufacturing a laminate structure according to an embodiment of the present invention;
FIG. 5 is an oblique view showing a part of a first example of the process for manufacturing a laminate structure according to an embodiment of the present invention;
FIG. 6 is an oblique view showing a part of a first example of the process for manufacturing a laminate structure according to an embodiment of the present invention;
FIG. 7 is an oblique view showing a part of a first example of the process for manufacturing a laminate structure according to an embodiment of the present invention;
FIG. 8 is an oblique view showing a part of a first example of the process for manufacturing a laminate structure according to an embodiment of the present invention;
FIG. 9 is an oblique view showing a part of a second example of the process for manufacturing a laminate structure according to an embodiment of the present invention;
FIG. 10 is an oblique view showing a part of a second example of the process for manufacturing a laminate structure according to an embodiment of the present invention;
FIG. 11 is an oblique view showing a part of a second example of the process for manufacturing a laminate structure according to an embodiment of the present invention;
FIG. 12 is an oblique view showing a part of a second example of the process for manufacturing a laminate structure according to an embodiment of the present invention;
FIG. 13 is an oblique view showing a part of a second example of the process for manufacturing a laminate structure according to an embodiment of the present invention;
FIG. 14 is an oblique view showing a part of a third example of the process for manufacturing a laminate structure according to an embodiment of the present invention;
FIG. 15 is an oblique view showing a part of a third example of the process for manufacturing a laminate structure according to an embodiment of the present invention;
FIG. 16 is an oblique view showing a part of a third example of the process for manufacturing a laminate structure according to an embodiment of the present invention;
FIG. 17 is an oblique view showing a part of a third example of the process for manufacturing a laminate structure according to an embodiment of the present invention;
FIG. 18 is an oblique view showing a part of a third example of the process for manufacturing a laminate structure according to an embodiment of the present invention;
FIG. 19 is an oblique view showing a third example of the construction of a laminate structure according an embodiment of the present invention;
FIG. 20 is an oblique view showing a part of a fourth example of the process for manufacturing a laminate structure according to an embodiment of the present invention;
FIG. 21 is an oblique view showing a part of a fourth example of the process for manufacturing a laminate structure according to an embodiment of the present invention;
FIG. 22 is an oblique view showing a part of a fourth example of the process for manufacturing a laminate structure according to an embodiment of the present invention;
FIG. 23 is an oblique view showing a part of a fourth example of the process for manufacturing a laminate structure according to an embodiment of the present invention;
FIG. 24 is an oblique view showing a part of a fifth example of the process for manufacturing a laminate structure according to an embodiment of the present invention;
FIG. 25 is an oblique view showing a part of a fifth example of the process for manufacturing a laminate structure according to an embodiment of the present invention;
FIG. 26 is an oblique view showing a part of a fifth example of the process for manufacturing a laminate structure according to an embodiment of the present invention;
FIG. 27 is an oblique view showing a part of a fifth example of the process for manufacturing a laminate structure according to an embodiment of the present invention;
FIG. 28 is an oblique view showing a part of a fifth example of the process for manufacturing a laminate structure according to an embodiment of the present invention;
FIG. 29 is an oblique view showing a modification of a laminate structure according to an embodiment of the present invention;
FIG. 30 is a cross sectional view for explaining the problem inherent in the prior art; and
FIG. 31 is a cross sectional view for explaining the problem inherent in the prior art.

Some embodiments of the present invention will now be described with reference to the accompanying drawings.

### (Construction 1)

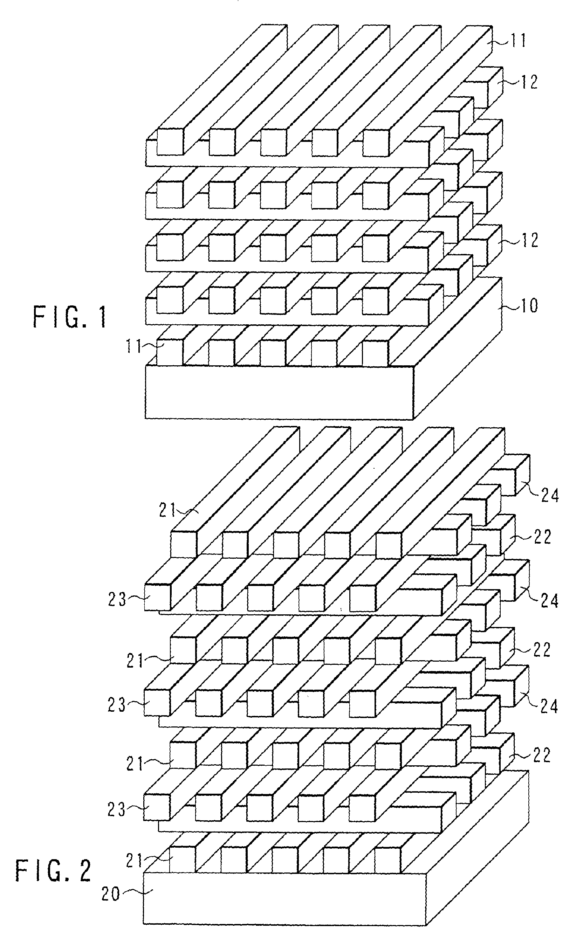

FIG. 1 schematically shows a first example of the construction of a three dimensional laminate structure according to the present invention. In the example shown in FIG. 1, five patterned photosensitive material layers 11 and four patterned photosensitive material layers 12 are laminated one upon the other on a substrate 10 consisting of, for example, a semiconductor substrate. These five patterned photosensitive material layers 11 have the same photosensitive characteristics. Likewise, these four patterned photosensitive material layers 12 have the same photosensitive characteristics. On the other hand, the photosensitive material layers 11 differ from the photosensitive material layers 12 in the photosensitive characteristics.

In manufacturing the three dimensional structure shown in FIG. 1, the surface of the substrate 10 is alternately coated with the photosensitive material layers 11 and 12 to form a laminated photosensitive layer. Then, the laminated photosensitive layer is exposed to light under different light exposure conditions by using a mask for forming a pattern of the photosensitive material layer 11 and another mask for forming a pattern of the photosensitive material layer 12, followed by a developing treatment, thereby obtaining the structure as shown in FIG. 1. In the light exposure step, light (visible light or ultraviolet light), an X-ray, an electron beam or an ion beam is used as the energy source.

Since all the photosensitive material layers 11 have the same photosensitive characteristics, it is possible to apply the light exposure treatment collectively to these photosensitive material layers simultaneously. Also, the photosensitive material layers 12 have the same photosensitive characteristics, making it possible to apply the light exposure treatment collectively to these photosensitive material layers 12 simultaneously. It should be noted that, since the photosensitive material layer 11 differs from the photosensitive material layer 12 in the photosensitive characteristics as described above, one of these photosensitive material layers is not allowed to respond to light during the light irradiating step of the other photosensitive material layer. It follows that it is possible to manufacture a three dimensional laminate structure having a periodic structure with a small number of manufacturing steps. It is also possible to obtain a very high pattern position accuracy among the photosensitive material layers having the same photosensitive characteristics.

It should also be noted that, since the light exposure and development are performed after the coating of the photosensitive layers 11 and 12, the photosensitive material layer on the upper side is not formed in regions between adjacent patterns of the photosensitive material layer on the lower side in the step of coating the upper side photosensitive material layer. It follows that a part of the photosensitive material layer on the upper side is formed not in contact with the photosensitive material layer on the lower side, making it possible to form a three dimensional laminate structure having a void (vacancy) region.

In order to prepare photosensitive material layers differing from each other in the photosensitive characteristics, it suffices to permit the photosensitive material layers to be different from each other in the sensitivity in accordance with the characteristics (kind, wavelength, etc.) of the energy source used for the light exposure such as light, an X-ray, an electron beam or an ion beam. In other words, the light exposure is applied to photosensitive material layers having different photosensitive characteristics under different light exposure conditions by using at least one of light, an X-ray, an electron beam and an ion beam as the energy source. For example, where the light exposure is applied to the photosensitive material layers 11 and 12 by using light, these photosensitive materials are made different from each other in the spectral response characteristics. It is also possible to permit the photosensitive material to exhibit different photosensitive characteristics depending on the kind of the energy source used for the light exposure. For example, the photosensitive material layer 11 is made of a material that responds to an ultraviolet light while using a material that responds to an electron beam for forming the photosensitive material layer 12. Incidentally, it is possible to permit the photosensitive material layers differing from each other in the photosensitive characteristics to be different from each other in the characteristics relative to at least one of the heat treatment after the light exposure and the developing treatment.

### (Construction 2)

FIG. 2 schematically shows a second example of the construction of a three dimensional laminate structure of the present invention. In the example shown in FIG. 2, a plurality of patterned photosensitive material layers 21 to 24 are laminated one upon the other on a substrate 20 formed of, for example, a semiconductor substrate. The photosensitive material layers 21 and 22 are made of a positive type photosensitive material in which the light-exposed region is removed in the subsequent developing treatment. On the other hand, the photosensitive material layers 23 and 24 are made of a negative type photosensitive material in which the region that is not subjected to the light exposure is removed in the subsequent developing treatment. A plurality of the photosensitive material layers 21 have the same photosensitive characteristics. A plurality of the photosensitive material layers 22 have the same photosensitive characteristics. A plurality of the photosensitive material layers 23 have the same photosensitive characteristics. Further, a plurality of the photosensitive material layers 24 have the same photosensitive characteristics. The positive photosensitive material layer 21 is substantially equal to the negative photosensitive material layer 23 in the photosensitive characteristics. Also, the positive photosensitive material layer 22 is substantially equal to the negative photosensitive material layer 24 in the photosensitive characteristics. On the other hand, the positive photosensitive material layers 21 and 22 differ from each other in the photosensitive characteristics. Also, the negative photosensitive material layers 23 and 24 differ from each other in the photosensitive characteristics.

In the example shown in FIG. 2, a laminated photosensitive layer is formed by coating the surface of the substrate 20 with the photosensitive material layers 21 to 24 as in the example shown in FIG. 1. Then, these photosensitive material layers are collectively subjected to the light exposure by using a mask for forming patterns of the positive photosensitive material layer 21 and the negative photosensitive material layer 23 having substantially the same photosensitive characteristics. Also, these photosensitive material layers are collectively subjected to the light exposure by using a mask for forming patterns of the positive photosensitive material layer 22 and the negative photosensitive material layer 24 having substantially the same photosensitive characteristics. Then, a developing treatment is performed so as to obtain a structure as shown in FIG. 2.

Incidentally, the second example shown in FIG. 2 is equal to the first example shown in FIG. 1 in the energy source used for the light exposure and means for making the photosensitive material layers different from each other in the photosensitive characteristics.

The construction of the second example produces the effects similar to those produced by the construction of the first example. For example, it is possible to manufacture a three dimensional laminate structure of a periodic structure having a very high position accuracy with a small number of manufacturing steps. Also, it is possible to manufacture easily a complex three dimensional laminate structure by using positive and negative type photosensitive material layers having substantially the same photosensitive characteristics.

Incidentally, it is possible to manufacture a three dimensional laminate structure of a further complicated construction in each example of constructions 1 and 2 by further increasing the kinds of the photosensitive material layers that are laminated one upon the other.

When it comes to the combination of the photosensitive material layers having different photosensitive characteristics, it is possible to employ the combination of chemically amplified photoresist materials for deep ultraviolet ray having different photosensitive wavelength characteristics. For example, it is possible to employ the combination of a polyhydroxystyrene series resist and polymethyl methacrylate. It is also possible to employ the combination of a chemically amplified photoresist for a deep ultraviolet ray and a chemically amplified photoresist for an i-ray having a permeability to the deep ultraviolet ray. Further, it is possible to select appropriately various photosensitive resist materials developed for the fine processing and to use these photosensitive resist materials in various combinations.

### (Manufacturing Process 1)

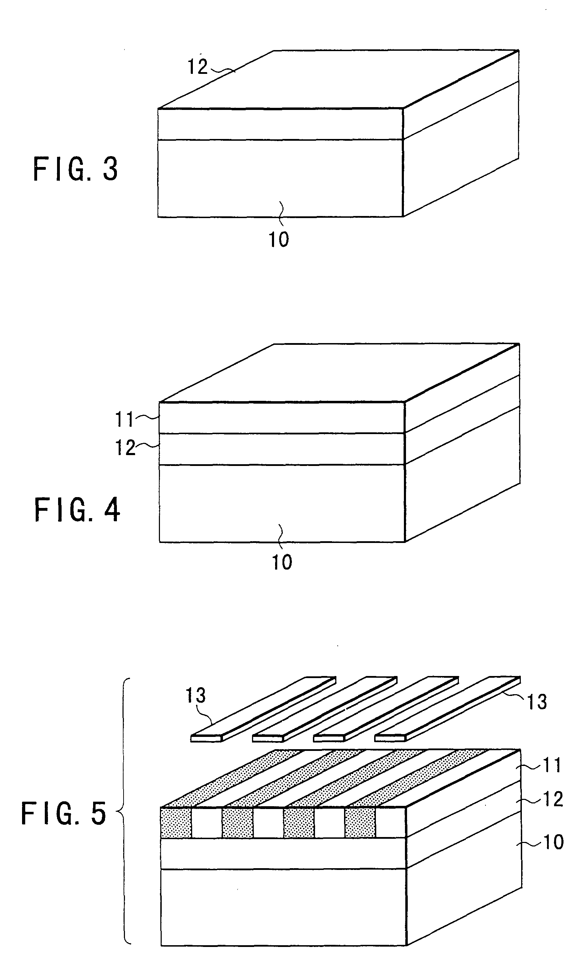

A first manufacturing process of a laminate structure according to an embodiment of the present invention will now be described with reference to FIGS. 3 to 8. This manufacturing process corresponds to the case where two photosensitive material layers are laminated one upon the other in construction 1 shown in FIG. 1.

In the first step, the substrate 10 formed of, for example, a semiconductor substrate is coated with the photosensitive material layer 12 as shown in FIG. 3, followed by applying a baking treatment (temperature elevating treatment) for the drying purpose. Then, the photosensitive material layer 12 is coated with the photosensitive material layer 11 as shown in FIG. 4, followed by applying a baking treatment (temperature elevating treatment) for the drying purpose.

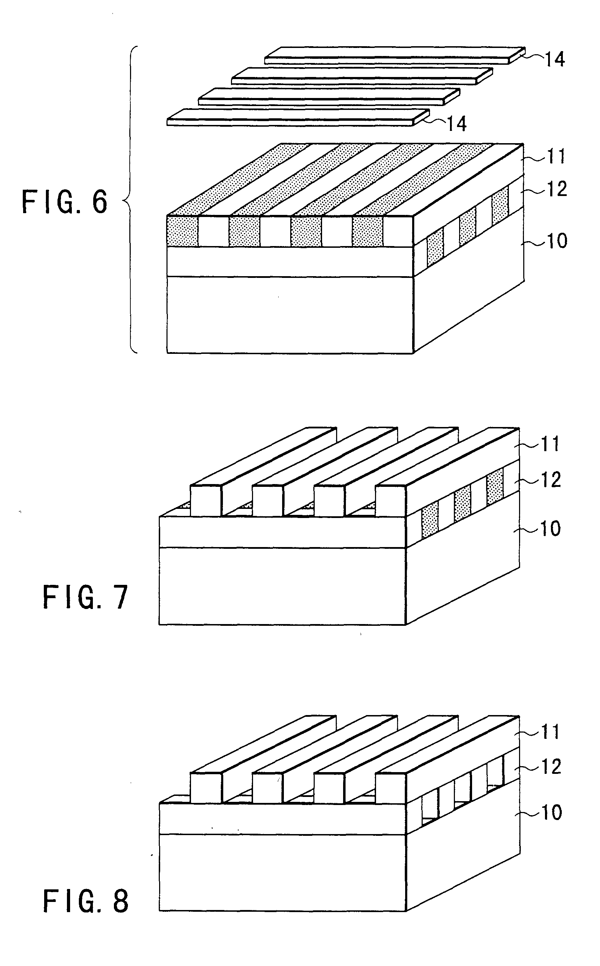

In the next step, light exposure is applied by using a mask 13, as shown in FIG. 5. The light exposure is performed under the conditions that the photosensitive material layer 11 alone is selectively allowed to respond to light while the photosensitive material layer 12 is not allowed to respond to light. As a result, the pattern of the mask 13 is transferred to the photosensitive material layer 11 alone. The light-exposed region is shown shaded in the drawing.

Then, an additional light exposure is performed by using a mask 14 differing from the mask 13, as shown in FIG. 6. The light exposure in this step is performed under the condition that the photosensitive material layer 12 alone is selectively allowed to respond to light while the photosensitive material layer 11 is not allowed to respond to light. As a result, the pattern of the mask 14 is transferred selectively into the photosensitive material layer 12. Then, a heat treatment (heat treatment after light exposure) is performed as required in order to increase the sensitivity.

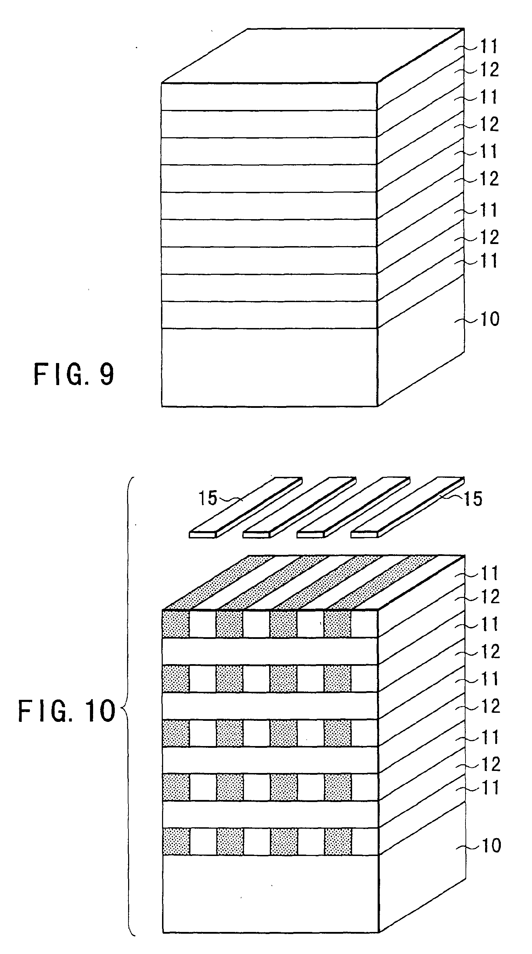

In the next step, the photosensitive material layer 11 alone is selectively developed to form a pattern of the photosensitive material layer 11, as shown in FIG. 7. Further, the photosensitive material layer 12 alone is selectively developed to form a pattern of the photosensitive material layer 12, as shown in FIG. 8. As a result, formed is a three dimensional laminate structure consisting of the photosensitive material layers 11 and 12. Incidentally, it is not absolutely necessary to selectively develop the photosensitive material layers 11 and 12. Where it is possible to develop the photosensitive material layers 11 and 12 with the same developing agent, it is of course possible to perform the development by using the same developing agent.

### (Manufacturing Process 2)

A second manufacturing process of a laminate structure according to an embodiment of the present invention will now be described with reference to FIGS. 9 to 13. This manufacturing process can be employed for manufacturing the laminate structure of construction 1 shown in FIG. 1.

In the first step, the surface of the substrate 10 formed of, for example, a semiconductor substrate is coated with a laminated photosensitive layer consisting of the photosensitive material layers 11 and 12, as shown in FIG. 9. To be more specific, the surface of the substrate 10 is coated first with the photosensitive material layer 11, followed by applying a baking treatment for the drying purpose. Then, the photosensitive material layer 11 is coated with the photosensitive material layer 12, followed by applying a baking treatment for the drying purpose. These steps are repeated several times to form a plurality of the photosensitive material layers 11 and a plurality of the photosensitive material layers 12.

In the next step, light exposure is performed by using a mask 15, as shown in FIG. 10. In this step, the light exposure is performed under the condition that the photosensitive material layers 11 alone are selectively allowed to respond to light while the photosensitive material layers 12 is not allowed to respond to light. Since the plural photosensitive material layers 11 have the same photosensitive characteristics, the same pattern is collectively transferred to all the photosensitive material layers 11.

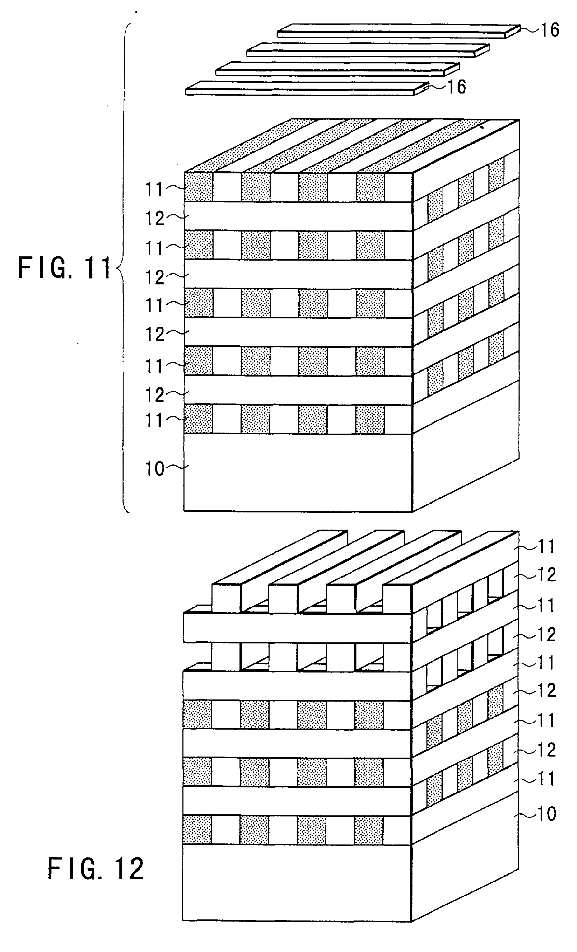

In the next step, an additional light exposure is performed by using a mask 16 differing from the mask 15, as shown in FIG. 11. The light exposure in this step is performed under the condition that the plural photosensitive material layers 12 alone are selectively allowed to respond to light while the photosensitive material layers 11 are not allowed to respond to light. Since all the photosensitive material layers 12 have the same photosensitive characteristics, the same pattern is transferred to all the photosensitive material layers 12. Then, a heat treatment (heat treatment after light exposure) is performed as desired in order to increase the sensitivity.

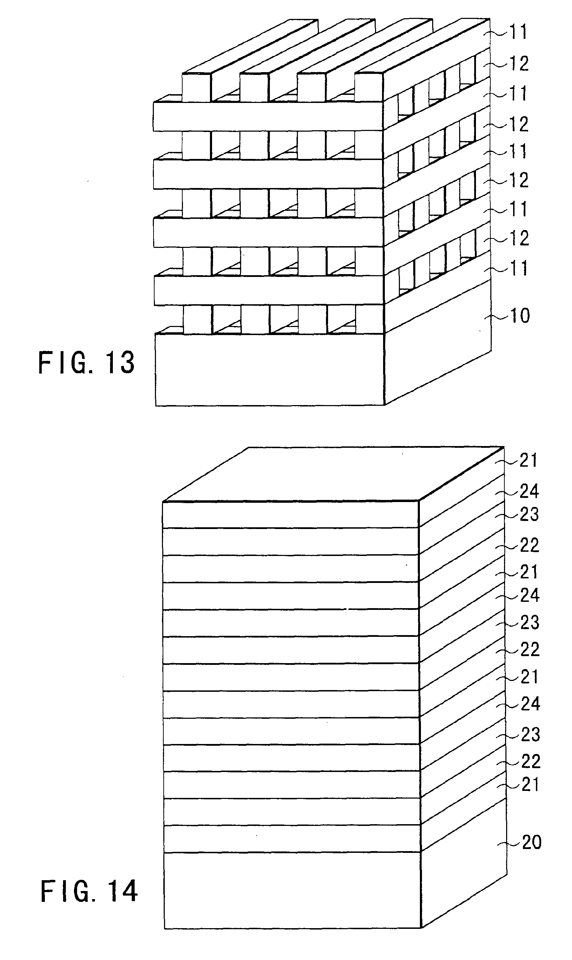

Further, a developing treatment is applied successively to the photosensitive material layers 11 and 12, starting with the uppermost photosensitive material layer 11, to form patterns of the photosensitive material layers 11 and 12, as shown in FIG. 12. As a result, formed is a three dimensional laminate structure of a periodic structure consisting of the photosensitive material layers 11 and 12, as shown in FIG. 13.

### (Manufacturing Process 3)

A third manufacturing process of a laminate structure according to an embodiment of the present invention will now be described with reference to FIGS. 14 to 18. This manufacturing process can be employed for manufacturing the laminate structure of construction 2 shown in FIG. 2.

In the first step, a laminated photosensitive layer consisting of the positive type photosensitive material layers 21 and 22 and the negative type photosensitive material layers 23 and 24 is formed on the substrate 20 formed of, for example, a semiconductor substrate. To be more specific, the surface of the substrate 20 is coated first with the photosensitive material layer 21, followed by applying a baking treating for the drying purpose. Then, the coating and baking treatments are applied successively for forming the photosensitive material layers 22, 23 and 24. These treatments are repeated so as to form a plurality of the photosensitive material layers 21 to 24.

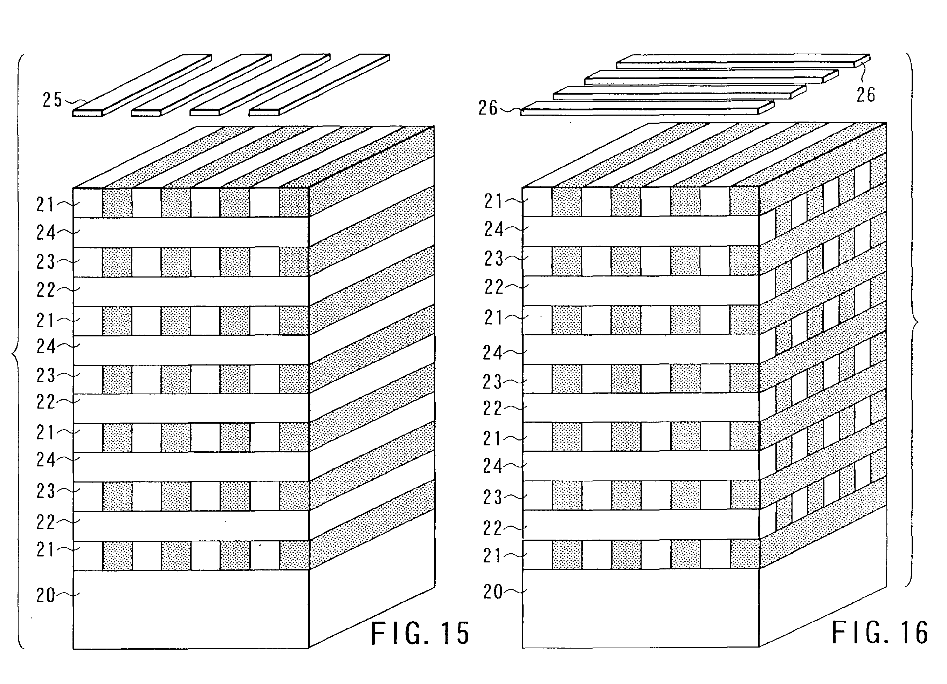

In the next step, light exposure is performed by using a mask 25, as shown in FIG. 15. The light exposure is performed in this step under the condition that the photosensitive material layers 21 and 23 alone are selectively allowed to respond to light while the photosensitive material layers 22 and 24 are not allowed to respond to light. It should be noted that all the positive photosensitive material layers 21 have the same photosensitive characteristics. Also, all the negative photosensitive material layers 23 have the same photosensitive characteristics. Further, the positive photosensitive material layer 21 and the negative photosensitive material layer 23 are substantially equal to each other in the photosensitive characteristics. As a result, all the photosensitive material layers 21 and 23 are collectively exposed to light to form the same light exposure pattern.

In the next step, light exposure is performed by using a mask 26 differing from the mask 25, as shown in FIG. 16. The light exposure is performed in this step under the condition that the photosensitive material layers 22 and 24 alone are selectively allowed to respond to light while the photosensitive material layers 21 and 23 are not allowed to respond to light. It should be noted that all the positive photosensitive material layers 22 have the same photosensitive characteristics. Also, all the negative photosensitive material layers 24 have the same photosensitive characteristics. In addition, the positive photosensitive material layer 22 is substantially equal to the negative photosensitive material layer 24 in the photosensitive characteristics. It follows that all the photosensitive material layers 22 and 24 are collectively exposed to light so as to obtain the same light exposure pattern. After the light exposure treatment, a heat treatment (heat treatment after light exposure) is performed as desired in order to increase the sensitivity.

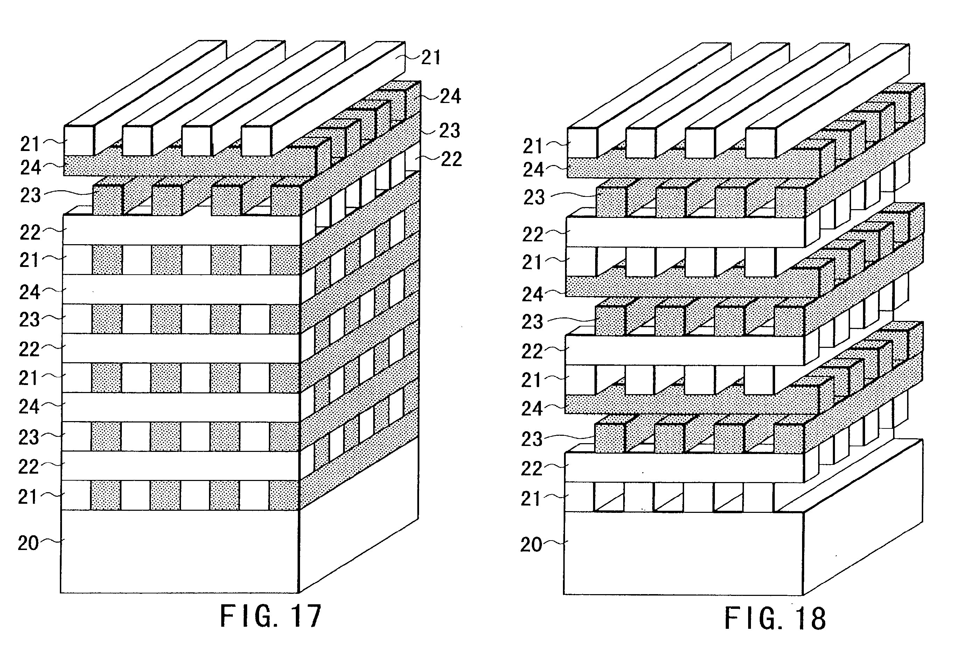

In the next step, a developing treatment is applied successively to the photosensitive material layers 21 to 24, starting with the uppermost photosensitive material layer 21, so as to form patterns of the photosensitive material layers 21 to 24. It should be noted that the positive photosensitive material layer 21 and the negative photosensitive material layer 23 are simultaneously exposed to light by using the same mask. Therefore, the pattern of the negative photosensitive material layer 23 is equal to the inverse pattern of the positive photosensitive material layer 21. Similarly, the pattern of the negative photosensitive material layer 24 is equal to the inverse pattern of the positive photosensitive material layer 22. In this fashion, prepared is a three dimensional laminate structure of a periodic structure consisting of the photosensitive material layers 21 to 24, as shown in FIG. 18.

### (Construction 3)

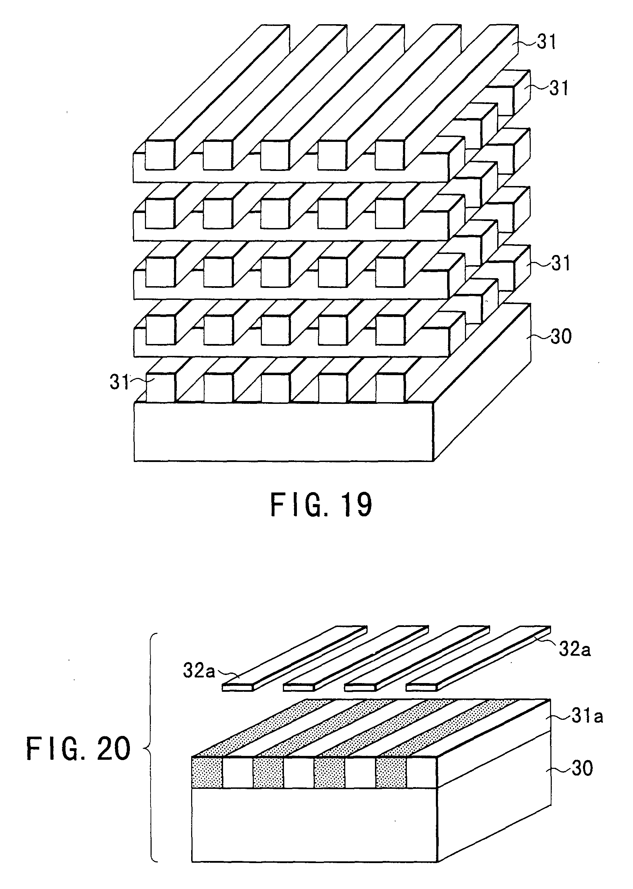

FIG. 19 schematically shows a third example of the construction of a three dimensional laminate structure of the present invention.

In the example shown in FIG. 19, a plurality of patterned photosensitive material layers 31 are laminated on a substrate 30 formed of, for example, a semiconductor substrate. It is possible for all of these photosensitive material layers 31 to have the same photosensitive characteristics. Alternatively, it is possible for at least one photosensitive material layer 31 to have photosensitive characteristics differing from those of the other photosensitive material layers 31.

Construction 3 shown in FIG. 19 is equal to each of constructions 1 and 2 shown in FIGS. 1 and 2 described previously, respectively, in the energy source used for the light exposure and the means for making the photosensitive material layers different from each other in the photosensitive characteristics.

As shown in FIG. 19, the substrate 30 is coated with at least one photosensitive material layer 31, followed by applying light exposure to the coated photosensitive material layer 31 by using a mask for forming a pattern. In the case of forming the photosensitive material layers 31 differing from each other in the photosensitive characteristics, the light exposure is performed under different light exposure conditions. In the subsequent process, the similar steps of forming at least one photosensitive material layer 31 and, then, applying a light exposure treatment to the photosensitive material layer 31 thus formed are repeated as required, thereby forming a laminated photosensitive layer as shown in FIG. 19 consisting of a plurality of photosensitive material layers having patterns transferred thereto.

In the example shown in FIG. 19, the light exposure is applied first to the laminated photosensitive material layers 31 formed on the substrate 30 and, then, a developing treatment is carried out as in the example shown in FIG. 1. Therefore, in the step of coating an upper photosensitive material layer on a lower photosensitive material layer, the upper photosensitive material layer does not enter a region between adjacent patterns of the lower photosensitive material layer. It follows that a part of the upper photosensitive material layer is not in contact with the lower photosensitive material layer, making it possible to obtain a three dimensional laminate structure having void regions.

Also, in the third construction shown in FIG. 19, the coating and light exposure treatments are repeated several times in place of collectively applying the light exposure treatment after formation of all the photosensitive material layers 31. Where the light exposure treatment is applied collectively to all the photosensitive material layers 31, it is necessary for light or an electron beam to pass without fail through each of the photosensitive material layers 31. Therefore, it is necessary to study carefully the attenuation characteristics of light and the electron beam within each of the photosensitive material layers. In construction 3 shown in FIG. 19, however, the coating and light exposure treatments are repeated several times, making it possible not to pay careful attentions to the attenuation characteristics of light and the electron beam within each of the photosensitive material layers 31. In other words, the light exposure can be applied without fail to each of the photosensitive material layers 31 even if a large number of photosensitive material layers 31 are laminated one upon the other.

### (Manufacturing Process 4)

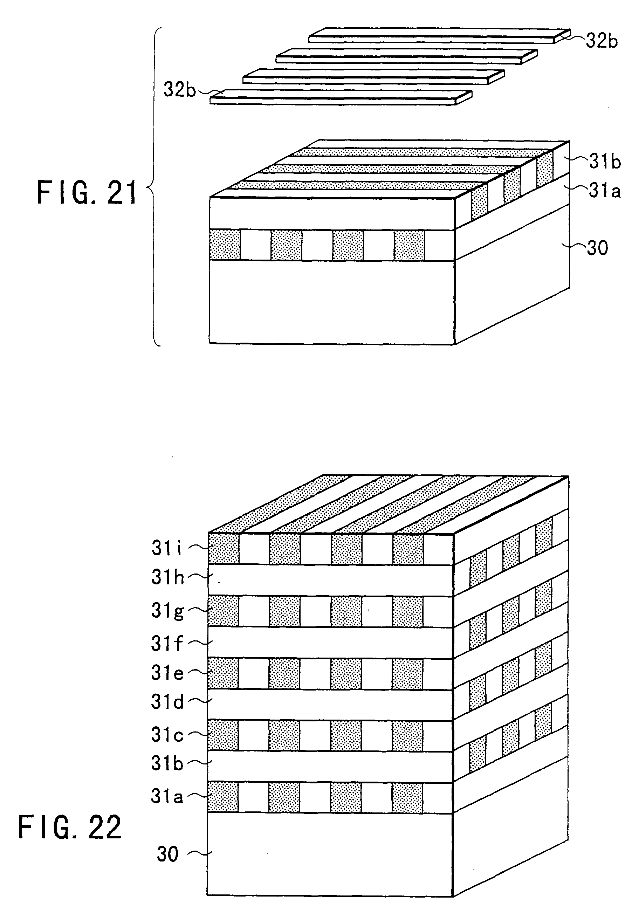

A fourth manufacturing process of a laminate structure according to an embodiment of the present invention will now be described with reference to FIGS. 20 to 23. This manufacturing process can be employed for manufacturing the laminate structure of construction 3 shown in FIG. 19.

In the first step, the surface of the substrate 30 formed of, for example, a semiconductor substrate is coated with a first photosensitive material layer 31a, followed by applying a baking treating (temperature elevation treatment) for the drying purpose. Then, light exposure is performed by using a mask 32a so as to transfer the pattern of the mask 32a onto the photosensitive material layer 31a, followed by applying a heat treatment (heat treatment after light exposure), as required, for increasing the sensitivity.

In the next step, the surface of the first photosensitive material layer 31a subjected to the light exposure treatment is coated with a second photosensitive material layer 31b, as shown in FIG. 21, followed by applying a baking treatment for the drying purpose. Then, light exposure is performed by using a mask 32b so as to transfer the pattern of the mask 32b onto the photosensitive material layer 31b, followed by applying a heat treatment after the light exposure, as required. Incidentally, in order to suppress the limitation of the process conditions, the photosensitive characteristics of the second photosensitive material layer 31b are made to differ from the photosensitive characteristics of the first photosensitive material layer 31a. Also, if the process conditions are strictly controlled, it is possible to use the same photosensitive material for forming the first photosensitive material layer 31a and the second photosensitive material layer 31b. To be more specific, it is possible to use the same photosensitive material by selecting the light exposure amount, the conditions for the heat treatment, etc. such that the first photosensitive material layer 31a is not exposed to light in the step of applying a light exposure to the second photosensitive material layer 31b.

By successively repeating the coating and light exposure treatments in this fashion for forming each of photosensitive material layers 31a to 31i, it is possible to form a laminated photosensitive layer structure having a desired pattern transferred to each layer, as shown in FIG. 22.

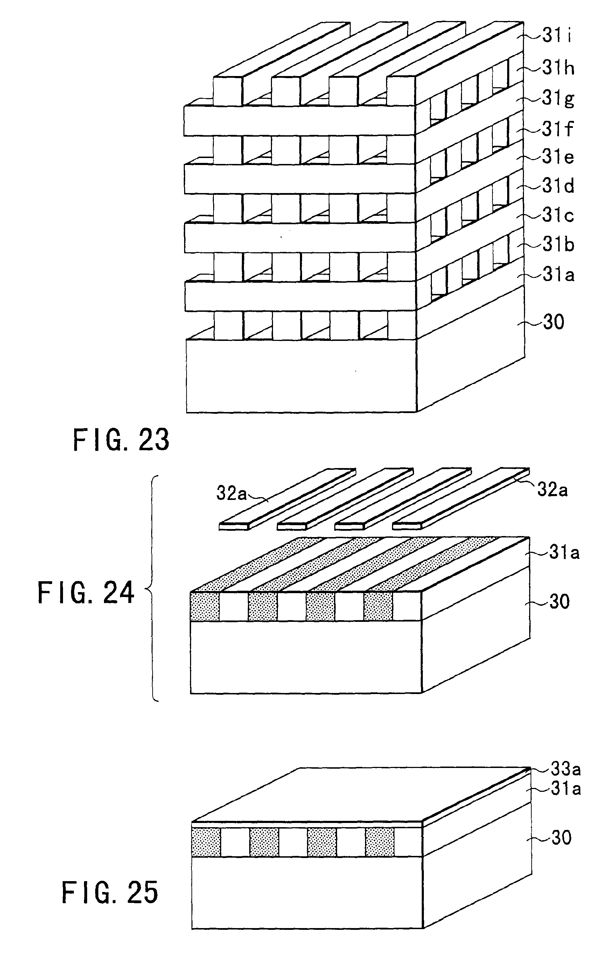

Finally, a developing treatment is successively applied to the photosensitive material layers 31a to 31i, starting with the uppermost photosensitive material layer 31i, so as to form a three dimensional laminate structure consisting of the photosensitive material layers 31a to 31i, as shown in FIG. 23. Further, it is possible to apply a final baking treatment (temperature elevation treatment), as required, for the stabilizing purpose.

### (Manufacturing Process 5)

A fifth manufacturing process of a laminate structure according to an embodiment of the present invention will now be described with reference to FIGS. 24 to 28. This manufacturing process can be employed for manufacturing the laminate structure of construction 3 shown in FIG. 19, in which a non-photosensitive material layer is formed between two adjacent photosensitive material layers.

In the first step, the surface of the substrate 30 formed of, for example, a semiconductor substrate is coated with a first photosensitive material layer 31a, followed by applying a baking treatment (temperature elevation treatment) for the drying purpose. Then, a light exposure is applied by using a mask 32a so as to transfer the pattern of the mask 32a onto the photosensitive material layer 31a. Further, a heat treatment (heat treatment after light exposure) is performed, as required, for increasing the sensitivity.

In the next step, a non-photosensitive material layer 33a is formed by, for example, evaporation or coating on the photosensitive material layer 31a subjected to the light exposure, as shown in FIG. 25. It is possible to use, for example, SOG for forming the non-photosensitive material layer 33a. By forming the non-photosensitive material layer 33a, it is possible to suppress the mixing in the coating step and developing step of the upper and lower photosensitive material layers adjacent to each other. It is also possible for the non-photosensitive material layer to be formed of a material that prevents light from being transmitted into the lower side photosensitive material layer in the step of applying a light exposure treatment to the upper side photosensitive material layer.

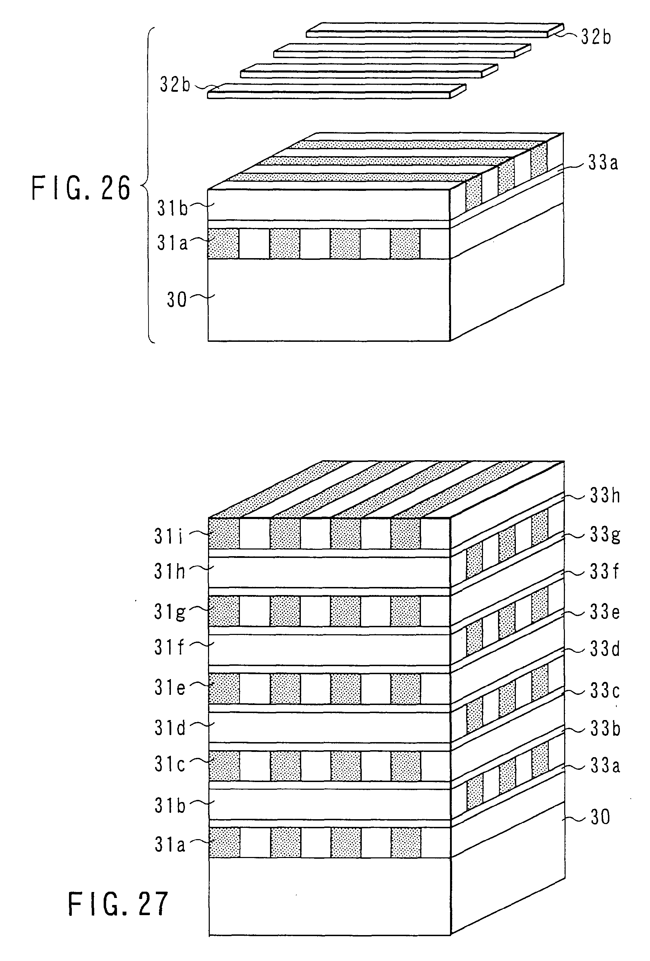

Then, the surface of the first non-photosensitive material layer 33a is coated with the second photosensitive material layer 31b, as shown in FIG. 26, followed by applying a baking treatment for the drying purpose. Further, a light exposure treatment is performed by using a mask 32b so as to transfer the pattern of the mask 32b onto the photosensitive material layer 31b, followed by applying a heat treatment after light exposure, as required. Incidentally, it is possible to use photosensitive materials having different photosensitive characteristics or same photosensitive characteristics for forming the photosensitive material layer 31a and the photosensitive material layer 31b, as in the fourth manufacturing process described previously.

In this fashion, the coating and light exposure for the photosensitive material layers 31a to 31i and the formation of the non-photosensitive material layers 33a to 33h are successively repeated, thereby forming a laminated photosensitive layer structure having a desired pattern transferred to each of the photosensitive material layers 31a to 31i and having the non-photosensitive material layers 33a to 33h formed between adjacent photosensitive material layers, as shown in FIG. 27.

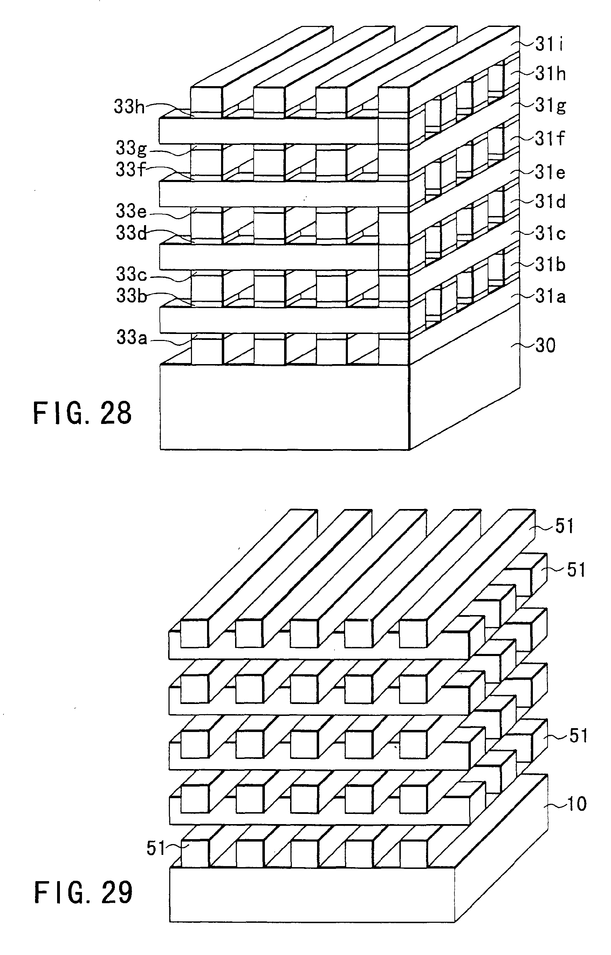

Finally, the development of the photosensitive material layers and the etching of the non-photosensitive material layers are successively performed, starting with the uppermost photosensitive material layer and with the uppermost non-photosensitive material layer, thereby forming a three dimensional laminate structure comprising the photosensitive material layers 31a to 31i and the non-photosensitive material layers 33a to 33h, as shown in FIG. 28. Further, it is possible to apply a final baking treatment (temperature elevation treatment), as required. The non-photosensitive material layers 33a to 33h are formed at intersections (overlapping portions) between adjacent photosensitive material layers in the laminating direction. It is possible to control the function of the entire three dimensional laminate structure by selecting appropriately the properties such as the optical properties of the non-photosensitive material layer.

As described above, in the fifth manufacturing process described above, non-photosensitive material layers are interposed between adjacent photosensitive material layers, making it possible to prevent the upper and lower photosensitive material layers from being mixed with each other. As a result, it is possible to improve the controllability of the shape and size of the three dimensional laminate structure.

In the fifth manufacturing process, a non-photosensitive material layer is interposed between adjacent photosensitive material layers in the manufacture of a laminate structure of construction 3 shown in FIG. 19. It is also possible to employ the fifth manufacturing method for forming a non-photosensitive material layer between adjacent photosensitive material layers in the manufacture of the laminate structure of construction 1 shown in FIG. 1 or construction 2 shown in FIG. 2.

It is possible to employ the three dimensional laminate structure of the present invention described above in, for example, an optical device. Also, the three dimensional laminate structure of the present invention is highly compatible with the lithography technology employed for the manufacture of a semiconductor integrated circuit and makes it possible to form a fine pattern having a size of the micrometer order in an optional position on a semiconductor substrate. It follows that it is possible to integrate the three dimensional laminate structure of the present invention together with a semiconductor device on the same semiconductor substrate.

In each of constructions 1 to 3 and manufacturing processes 1 to 5 described above, it is possible to employ additional steps after formation of the laminate structure described above.

First of all, the clearance of the laminate structure is loaded with fluid. It is possible for the fluid to consist of an inorganic material or an organic material. For example, the fluid consists of SOG.
Then, the fluid is solidified to form a solid material, followed by selectively removing the photosensitive material layers so as to leave the solid material unremoved.

By the addition of the process described above, it is possible to form a laminate structure in the clearance of the laminate structure formed previously. Specifically, it is possible to obtain a laminate structure formed of solid material layers 51 as shown in FIG. 29. Where the line pattern and the space pattern are formed of the same line width in the structure shown in, for example, FIG. 1, it is possible to manufacture a laminate structure of the shape similar to the shape of the structure shown in FIG. 1. Since various materials can be used for forming the particular laminate structure, it is possible to obtain a laminate structure made of various materials.

As described above, the developing treatment is carried out in the present invention after application of a light exposure treatment to a plurality of photosensitive material layers, making it possible to obtain a laminate structure of a high accuracy having a desired shape.

## Claims

1. A laminate structure prepared by laminating a plurality of photosensitive material layers (11, 12, 21-24, 31, 31a-31i) having desired patterns, wherein a. void is formed below an upper photosensitive material layer in a region where upper and lower photosensitive material layers adjacent to each other in the laminating direction do not overlap with each other.

2. The laminate structure according to claim 1, characterized in that at least one of said photosensitive material layers (11, 12, 21-24, 31, 31a-31i) differs from at least one of the other photosensitive material layers (11, 12, 21-24, 31, 31a-31i) in the photosensitive characteristics and the pattern.

3. The laminate structure according to claim 2, characterized in that the photosensitive material layers (11, 12, 21-24, 31, 31a-31i) having different photosensitive characteristics differ from each other in sensitivity depending on the characteristics of an energy source used for light exposure of the photosensitive material layer.

4. The laminate structure according to claim 2, characterized in that the energy source used for the light exposure of said photosensitive material layer (11, 12, 21-24, 31, 31a-31i) is selected from the group consisting of light, an X-ray, an electron beam, and an ion beam.

5. The laminate structure according to claim 2, characterized in that said plural photosensitive material layers comprise a positive type photosensitive material layer (21, 22) and a negative type photosensitive material layer (23, 24).

6. The laminate structure according to claim 2, characterized in that the photosensitive material layers (11, 12, 21-24, 31, 31a-31i) having different photosensitive characteristics differ from each other in the characteristics relative to at least one of a heat treatment after light exposure and a developing treatment.

7. The laminate structure according to claim 1, characterized in that a non-photosensitive material layer (33a-33h) is interposed between the patterns of the photosensitive material layers (31a-31i) adjacent to each other in the laminating direction.

8. A method of manufacturing a laminate structure, characterized by comprising the steps of:
laminating a plurality of photosensitive material layers (11, 12, 21-24, 31, 31a-31i) one upon the other to form a laminated photosensitive layer, the photosensitive characteristics of at least one of said photosensitive material layers (11, 12, 21-24, 31, 31a-31i) differing from those of the other photosensitive material layers (11, 12, 21-24, 31, 31a-31i);
applying a light exposure treatment to said laminated photosensitive layer a plurality of times under different light exposure conditions so as to transfer desired patterns to said plural photosensitive material layers (11, 12, 21-24, 31, 31a-31i); and
developing said plural photosensitive material layers (11, 12, 21-24, 31, 31a-31i) having said patterns transferred thereto.

9. The method of manufacturing a laminate structure according to claim 8, characterized in that the photosensitive material layers (11, 12, 21-24, 31, 31a-31i) having different photosensitive characteristics differ from each other in sensitivity depending on the characteristics of an energy source used for light exposure of the photosensitive material layer.

10. The method of manufacturing a laminate structure according to claim 8, characterized in that the energy source used for the light exposure of said photosensitive material layer (11, 12, 21-24, 31, 31a-31i) is selected from the group consisting of light, an X-ray, an electron beam and an ion beam.

11. The method of manufacturing a laminate structure according to claim 8, characterized in that said plural photosensitive material layers include a positive type photosensitive material layer (21, 22) and a negative type photosensitive material layer (23, 24).

12. The method of manufacturing a laminate structure according to claim 8, wherein the photosensitive material layers (11, 12, 21-24, 31, 31a-31i) having different photosensitive characteristics differ from each other in the characteristics relative to at least one of a heat treatment after light exposure and a developing treatment.

13. The method of manufacturing a laminate structure according to claim 8, characterized in that the step of forming the laminated photosensitive layer includes the process of interposing a non-photosensitive material layer (33a-33h) between the photosensitive material layers (31a-31i) adjacent to each other in the laminating direction.

14. The method of manufacturing a laminate structure according to claim 8, characterized by further comprising the steps of:
loading a fluid in the clearance among the plural photosensitive material layers (11, 12, 21-24, 31, 31a-31i) that have been patterned by the previous developing step;
solidifying the fluid to form a solid material (51); and
selectively removing the plural photosensitive material layers (11, 12, 21-24, 31, 31a-31i) so as to leave the solidified material (51) unremoved.

15. A method of manufacturing a laminate structure, characterized by comprising the steps of:
repeatedly performing treatments to form at least one photosensitive material layer (31a-31i) and to apply a light exposure treatment to said photosensitive material layer so as to transfer a desired pattern to the photosensitive material layer (31a-31i), thereby forming a laminated photosensitive layer consisting of a plurality of photosensitive material layers (31a-31i) having patters transferred thereto; and
developing the plural photosensitive material layers (31a-31i) having the patterns transferred thereto.

16. The method of manufacturing a laminate structure according to claim 15, characterized in that the step of forming the laminated photosensitive layer (31a-31i) includes the process of interposing a non-photosensitive material layer (33a-33h) between the photosensitive material layers adjacent to each other in the laminating direction.

17. The method of manufacturing a laminate structure according to claim 15, characterized by further comprising the steps of:
loading a fluid in the clearance among the plural photosensitive material layers (31a-31i) that have been patterned by the previous developing step;
solidifying the fluid to form a solid material (51); and
selectively removing the plural photosensitive material layers (31a-31i) so as to leave the solidified material (51) unremoved.
